# FASCICULE DE BREVET EUROPEEN

(11) **EP 0 903 811 B1**
(45) Date de publication et mention de la délivrance du brevet: **16.01.2008**
(21) Numéro de dépôt: 98402325.9
(22) Date de dépôt: 22.09.1998
(51) Int. Cl.: H01R 13/24, H05K 7/10

(54) **Intercalaire pour boitier micro-électronique et procédé de fabrication d'un tel intercalaire**
Zwischenstück für mikroelektronisches Gehäuse und Verfahren zur Herstellung eines solchen Zwischenstücks
Intermediate part for a microelectronic package and method of manufacturing such an intermediate part

(30) Priorité: 23.09.1997 FR 9711818
(43) Date de publication de la demande: 24.03.1999
(73) Titulaire: EADS ASTRIUM SAS, 31402 Toulouse Cedex 4 (FR)
(72) Inventeur: de Givry, Jacques, 78350 Les Loges en Josas (FR)
(74) Mandataire: Loisel, Bertrand

(56) Documents cités:
- WO-A-97/08781
- WO-A-97/11514
- US-A- 4 647 124
- US-A- 4 927 369
- US-A- 5 484 295

## Description

La présente invention concerne des intercalaires destinés à être insérés entre un boîtier micro-électronique à contacts répartis sur sa face intérieure et un circuit imprimé.

De tels intercalaires permettent de monter des boîtiers microélectroniques volumineux, présentant des contacts sur l'ensemble de leur face inférieure et non pas seulement à leur périphérie sur des cartes de circuit imprimé, sans nécessiter des assemblages par brasage, soudage ou collage qui rendent le montage et le démontage difficiles.

On a déjà réalisé des intercalaires destinés à remplir cette fonction mais ils présentent des inconvénients ou des limitations. On a par exemple proposé des intercalaires constitués par une feuille isolante dans laquelle sont ménagés des trous qui reçoivent chacun une pelote de fil de molybdène doré, répartis suivant le même réseau que les contacts sur le boîtier. Un inconvénient de cette disposition est que les pelotes ne peuvent se comprimer que très légèrement. En conséquence, certaines des liaisons électriques sont défectueuses lorsque le boîtier ou la carte présente des défauts de planéité, ce qui est souvent le cas. On a également proposé des intercalaires utilisant des contacts en élastomère conducteur. Mais la tenue à long terme de tels intercalaires est sujette à caution, notamment dans le cas d'applications spatiales, où l'intercalaire est soumis à des radiations.

On connaît également (WO-9708781) un contact électrique à faible self-inductance, présentant une forme de pincette découpée dans une feuille métallique dont les bras sont terminés par des becs destinés à entrer en contact l'un avec l'autre. Les surfaces latérales constituent des «major faces». Chaque contact est simplement contenu dans une ouverture dont il peut s'échapper.

L'invention vise notamment à fournir un intercalaire répondant mieux que ceux antérieurement proposés aux exigences de la pratique, notamment en ce qu'il est capable de tolérer des défauts de planéité importants et peut être réalisé sous une épaisseur très faible, inférieure à deux millimètres.

Dans ce but, l'invention propose notamment un intercalaire de liaison entre un boîtier micro-électronique à contacts répartis sur sa face inférieure et un circuit imprimé, conforme à la revendication 1.

L'intercalaire est utilisable avec des boîtiers microélectroniques de types très divers, pouvant comporter plusieurs centaines de contacts. Ces boîtiers peuvent notamment être des modules contenant plusieurs puces, des boîtiers à une seule puce ou des hybrides de plusieurs centimètres de côté.

Souvent, les trous seront de forme rectangulaire, de longueur au moins égale à cinq fois la largeur et de largeur juste suffisante pour laisser passer la lame. Pour améliorer la liaison électrique et la localiser de façon précise, chaque partie terminale d'une lame de contact peut présenter un renflement ou bossage d'appui sur un contact ou une plage. Chaque trou présentera alors en général une indentation de forme correspondant à celle du bossage, destinée à le laisser passer.

Dans une variante de réalisation, la plaquette isolante est constituée d'une embase et d'un couvercle emprisonnant des languettes de centrage de largeur supérieure à celle des lames, placées chacune entre les bras d'une lame. Chaque languette peut avoir deux dents latérales maintenant la lame écartée des arêtes latérales du trou correspondant. Les deux bras de la lame peuvent être fixés à la languette de centrage. Dans les deux cas, les trous de la plaquette ont une longueur suffisante pour livrer passage à la lame déjà pliée. Le matériau constitutif de la plaquette dépendra de l'application envisagée et aussi du mode des trous prévus. On peut notamment utiliser les composites verre-époxy et verre-polyimide et les résines de moulage telles que celles connues sous les marques "macrolon" et "ryton". Des trous de forme rectangulaire peuvent y être ménagés au laser ou à l'aide d'un jet d'eau sous très haute pression. Si en revanche il est important de favoriser le refroidissement du boîtier, on pourra utiliser un matériau isolant bon conducteur de la chaleur, tel que le nitrure d'aluminium.

L'intercalaire peut être réalisé de façon à n'occuper qu'une très faible épaisseur, d'environ 0,7 mm lorsqu'il est comprimé. Les lames de contact peuvent avoir une largeur inférieure au millimètre et une longueur de branche d'environ 4 mm, permettant de les répartir longitudinalement à un pas d'environ 5 mm et transversalement à un pas d'environ 1,9 mm.

L'invention propose également un procédé de fabrication d'un intercalaire du genre défini ci-dessus, conforme à la revendication 11.

Le pliage doit être réalisé dans des conditions telles que la saillie des bossages au repos soit suffisante pour accepter les défauts de planéité du boîtier ou de la carte de circuit imprimé. Dans la pratique, on peut sans difficultés prévoir un pliage tel que des déflexions dépassant 0,5 mm soient acceptables avant venue en butée.

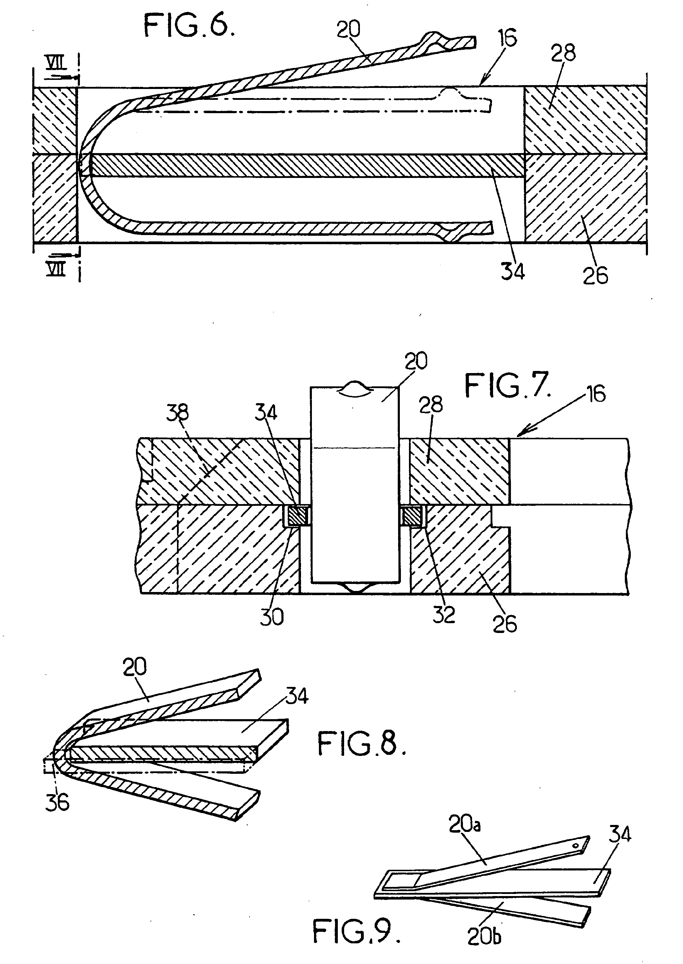

Les caractéristiques ci-dessus ainsi que d'autres apparaîtront mieux à la lecture de la description qui suit d'un mode particulier de réalisation de l'invention, donné à titre d'exemple non limitatif. Les modes de réalisations des figures 6-16 montrent des intercalaires qui ne sont pas couverts de l'invention. La description se réfère aux dessins qui l'accompagnent, dans lesquels :
- la figure 1 montre schématiquement un intercalaire placé entre un boîtier micro-électronique et un substrat constitué par une carte de circuit imprimé ;
- la figure 2 est un schéma de principe montrant la disposition d'une lame de contact entre une carte de circuit imprimé et un boîtier micro-électronique ;
- la figure 3 montre une répartition possible des trous de l'intercalaire ;
- la figure 4 est une vue de détail montrant une forme possible de lame ;
- la figure 5 est une vue en coupe suivant la ligne V-V de la figure 4 ;
- la figure 6 est une vue en coupe à grande échelle montrant une variante de réalisation ;
- la figure 7 est une vue en coupe suivant la ligne VII-VII de la figure 6 ;
- la figure 8 est une vue en perspective montrant une lame et une languette d'un intercalaire du genre montré en figures 6 et 7 ;
- la figure 9, similaire à la figure 8, montre une variante de réalisation ;
- la figure 10, similaire à la figure 6, montre le montage d'une lame de contact du type montré en figure 9 dans une plaquette, avec maintient longitudinal ;
- la figure 11 est une vue en coupe transversale à une lame de contact, montrant un mode possible de retenue de lame de contact dans une plaquette 16 en deux pièces ;
- la figure 12 montre une lame de contact selon une autre variante encore de réalisation ;
- la figure 13 est une vue en perspective montrant une fraction d'une embase de plaquette susceptible de recevoir des lames de contact du genre montré en figure 12 ;
- la figure 14 est une vue de détail en coupe montrant une coopération possible entre un intercalaire suivant l'invention et un interposeur épais ;
- la figure 15, similaire à la figure 2, montre une variante ; et
- la figure 16 est une vue en bout d'une barrette de réception de lames de contact suivant la figure 15.

Un intercalaire suivant l'invention, souvent dénommé interposeur, est destiné à réaliser des connexions électriques entre deux surfaces approximativement planes munies de contacts en regard, par simple pression. De telles liaisons électriques créées par pression permettent d'éviter la présence de brasures, de soudures ou de collages conducteurs qui compliquent la désolidarisation des surfaces. L'une des surfaces appartient à un substrat, généralement une carte de circuit imprimé, et l'autre à un boîtier micro-électronique. Ce boîtier sera souvent un module à plusieurs puces, souvent signé par l'abréviation anglo-saxonne "multi chip module". Le boîtier, généralement en céramique (alumine, nitrure d'aluminium, AlSiC, etc) est maintenu appliqué sur une carte de circuit imprimé, généralement multi-couches.

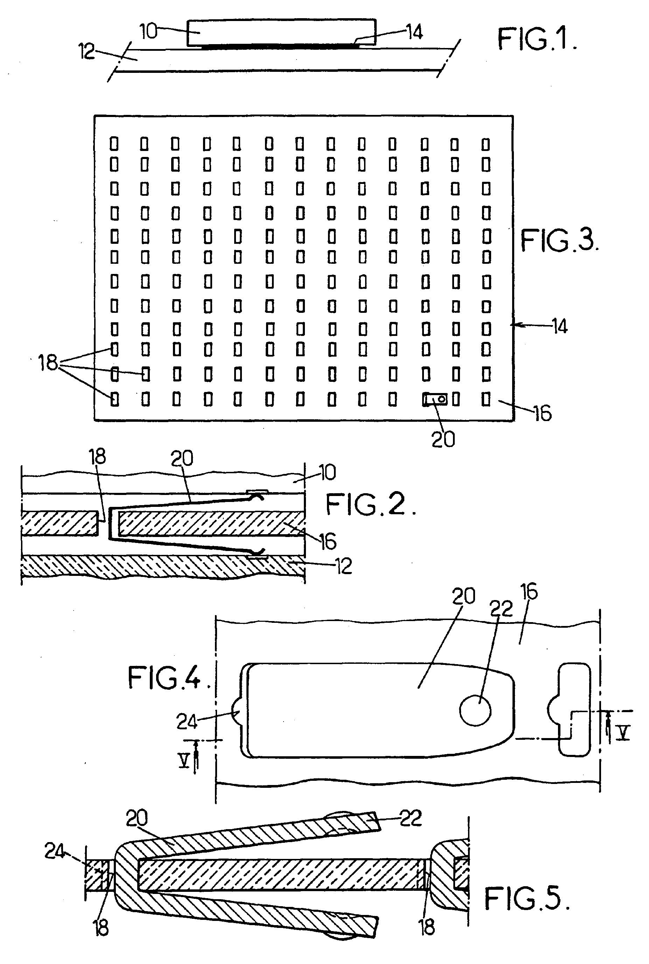

La figure 1 montre une telle disposition. Le boîtier 10, pressé contre le circuit imprimé 12 par des moyens non représentés, est séparé du circuit 12 par l'intercalaire 14. Des moyens de centrage non représentés permettent de fixer de façon précise la position de l'intercalaire 14 et du boîtier 10 par rapport au circuit imprimé 12.

L'intercalaire 14 permet de relier des contacts régulièrement répartis sur la face inférieure du boîtier 10 par des plages de contact du circuit imprimé 12. Les contacts et les plages sont constitués par des zones métalliques, généralement dorées, réparties suivant le même motif.

La figure 2 montre la constitution de principe de l'intercalaire. Il comporte une plaquette isolante 16 en matériau isolant électrique, d'épaisseur généralement inférieure à 1 mm. Dans la plaquette sont percés des trous 18 répartis suivant le même motif que les contacts. Ces trous sont de forme rectangulaire et destinés à recevoir des lames de contact minces 20 dont une seule est représentée sur la figure 2. L'isolant constitutif de la plaque 16 doit être de nature telle qu'il permette de percer des trous rectangulaires de faible dimension. On peut notamment utiliser le Delrin, le verre-epoxy, le verre-polyamide, des résines de moulage telle le Macrolon ou le Ryton qui peuvent être percées au laser ou au jet d'eau sous pression sous forme non circulaire. Dans d'autres cas, où il est souhaitable d'obtenir une conductivité thermique élevée, on peut utiliser des isolants tels que AlN. Pour des applications spatiales, on utilisera des matériaux à faible dégazage sous vide.

La lame 20 est constituée par un tronçon de ruban plié, en matériau élastique bon conducteur. On pourra notamment utiliser le cuivre au béryllium, protégé par nickelage et dorure. La lame présente une épaisseur très inférieure à sa largeur, par exemple 5 à 10 fois plus faible.

Pour mieux localiser les zones de contact sur la grande face de la lame, les parties terminales de la lame présentent avantageusement des bossages 22 qui peuvent être réalisés par poinçonnage. Ils constituent des grains de contact qui viennent s'appuyer sur le module et la carte en effectuant un auto-nettoyage lors de la flexion élastique des bras de la lame, sans risque de coincement. Une indentation 24 est alors prévue dans chaque trou pour livrer passage au grain.

On a notamment réalisé un intercalaire dont la plaque présente des trous répartis suivant un réseau rectangulaire de 1,905 x 5,08 mm et les lames ont une épaisseur de 0,1 mm et une largeur de 0,8 mm. Un tel intercalaire est notamment utilisable pour monter un module courant, ayant de 300 à 500 contacts.

L'invention est susceptible de nombreuses variantes de réalisation.

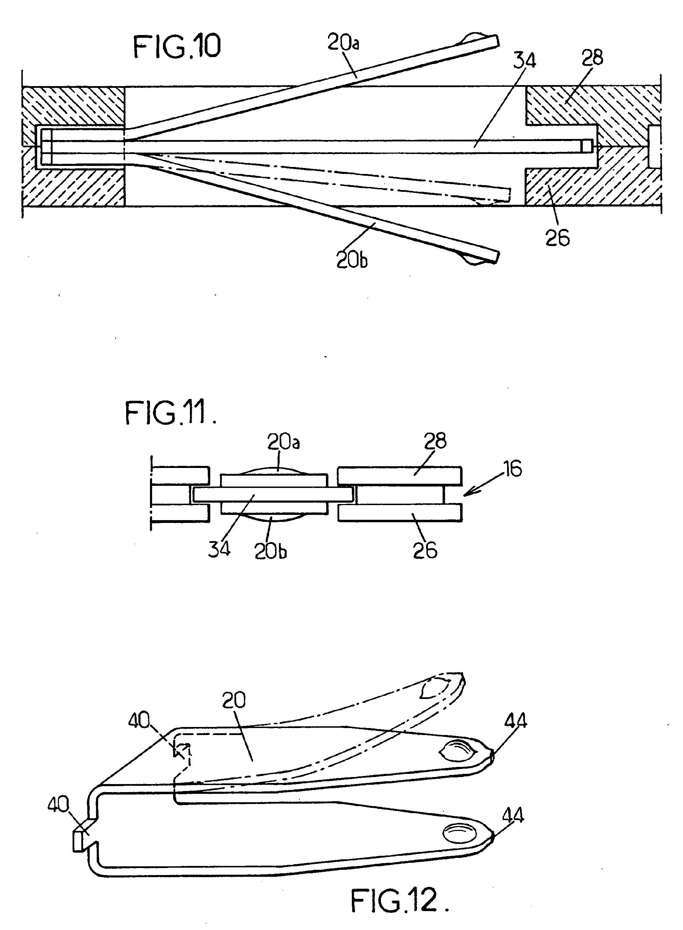

Dans le cas illustré en figures 6 et 7, la plaquette isolante 16 est constituée d'une embase 26 et d'un couvercle 28. Les trous aménagés dans l'embase 26 ont une largeur légèrement supérieure à celle des lames de contact et une longueur telle que les lames de contact puissent y être introduites déjà pliées en V. La lame 20 est représentée sur les figures 6 et 7 avec une branche à l'état libre et une branche à l'état de compression maximum, lorsque l'intercalaire est en place entre un boîtier microélectronique et un circuit imprimé. Le couvercle a un trou de même dimension. De plus, chaque trou de l'embase présente deux rainures latérales 30 et 32 qui constituent, lorsque le couvercle et l'embase sont assemblés, un logement de réception d'une languette de centrage 34 dont la largeur est telle qu'elle est emprisonnée entre le couvercle et l'embase. Cette languette présente à une extrémité deux dents latérales 36 destinées à emprisonner le pli de la lame 20 et à maintenir la lame écartée des bords du trou.

Dans ce mode de réalisation, chaque lame de contact peut être montée ou démontée individuellement. La dimension des trous permet de réaliser l'embase et le couvercle par moulage d'un matériau tel qu'une résine thermodurcissable isolante, sans usinage ultérieur. La languette est en matériau isolant ou conducteur, elle peut avoir une épaisseur aussi faible que 0,2 mm. Elle est fixée, temporairement ou définitivement, par un point de colle à la lame pour les opérations de mise en place.

Le montage s'effectue alors de la façon suivante. Les ensembles contact-languette sont placés sur l'embase, à l'aide d'un outil qui presse les bords de la plaquette contre l'embase. Une fois l'embase complètement équipée, on pose le couvercle et on le fixe. La fixation peut être réalisée à l'aide de microvis 38 (figure 7), qui remplacent quelques-unes des lames de contact des points du réseau.

Cette disposition permet de démonter un contact endommagé et de le remplacer.

Des lumières démunies de lames de contact peuvent être réservées pour permettre de positionner de façon précise l'intercalaire sur le circuit intégré et de le maintenir, lors du montage.

Dans la variante de réalisation montrée en figure 9, la lame élastique est en plusieurs pièces. Les deux bras 20a et 20b sont constitués de deux tronçons de ruban distincts et fixés à un troisième tronçon conducteur constituant la languette 34. Cette languette peut être plus large et/ou plus longue que les bras 20a et 20b. Chaque languette est emprisonnée dans une plaquette en deux pièces et fait office de centreur. Les deux bras sont préformés et placés de part et d'autre du centreur pour être fixés par soudure électrique en une seule opération.

Cette disposition permet d'atteindre une épaisseur minimale, de l'ordre de 0,8 mm, en utilisant comme centreur et comme bras des tronçons de rubans dé cuivre au béryllium de 0,1 mm d'épaisseur et comme languette un tronçon de pellicule verre epoxy de 150 mm d'épaisseur. En contrepartie, un tel intercalaire est plus coûteux que ceux précédemment décrits. Dans le cas illustré sur la figure 10, la languette est retenue par ses extrémités longitudinales. Dans le cas de la figure 11, elle est au contraire retenue latéralement.

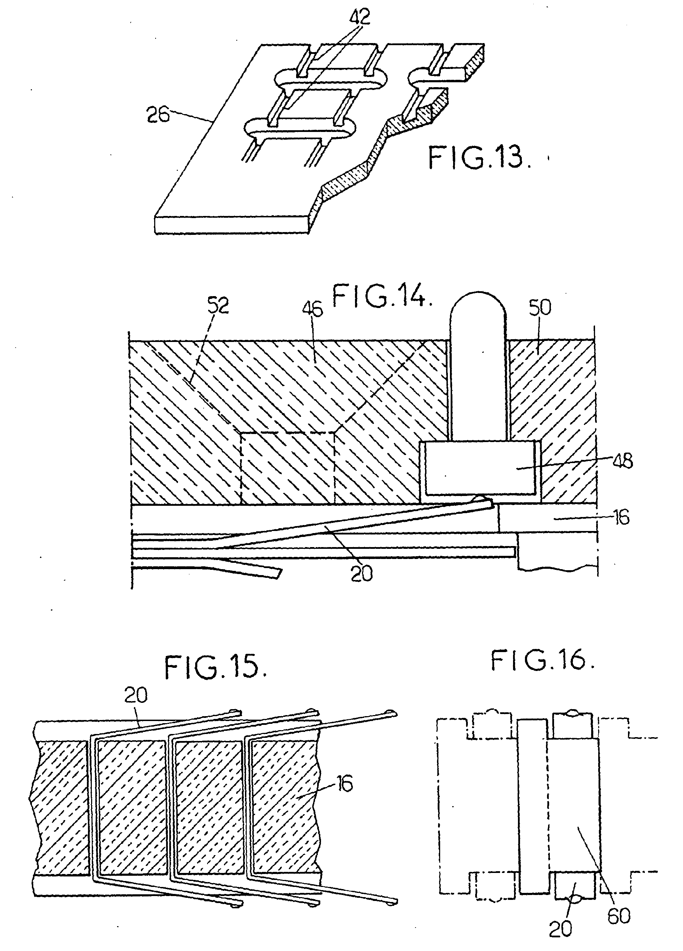

Dans la variante de réalisation montrée en figures 12 et 13, la lame de contact 20 est en une seule pièce, comme dans le cas des figures 2 et 6, mais elle présente, au niveau du pli, deux pattes latérales 40 qui permettent d'emprisonner la lame dans la plaquette isolante. Dans ce cas, l'embase 26 (figure 13) et le couvercle peuvent être identiques et fabriqués par usinage dans des plaques minces d'isolant. On voit sur la figure 13 que chaque trou destiné à livrer passage à une lame est raccordé aux trous adjacents par au moins une rainure 42 destinée à recevoir les pattes 40.

Les trous et les rainures peuvent être usinés ou obtenus par moulage. Dans le cas illustré sur la figure 13, chaque trou est relié aux trous adjacents par deux rainures, ce qui autorise un montage tête bêche des lames de contact.

Les bras de la lame de contact montrés en figure 13 ont une largeur qui décroît depuis l'emplanture jusqu'à l'extrémité, ce qui est avantageux du point de vue mécanique. Ils peuvent présenter au repos une cambrure, indiquée en traits mixtes sur la figure 12, de façon à être droits en position d'écrasement maximal. Les lames de contact peuvent être obtenues raccordées en bandes, par gravure chimique d'un ruban de cuivre au béryllium. Les contacts ainsi fournis en bande sont plats et leurs extrémités sont reliées à deux bandes de rive par une zone amincie, dont un résidu apparaît en 44 sur la figure 12.

Les pattes 40 jouent un rôle de charnière. De plus, elles limitent, par leur forme plate dans les rainures, le débattement angulaire des contacts, sans gêner leur mobilité. La forme effilée des bras évite que leurs bords ne viennent accrocher les arêtes limitant les trous dans l'isolant. Le couvercle peut avoir des trous et des rainures un peu plus large que l'embase afin de faciliter leur rapprochement.

L'intercalaire selon ce mode de réalisation peut lui aussi avoir une épaisseur très faible. L'embase et le couvercle peuvent avoir une épaisseur de 0,8 mm. Les lames de contact, en cuivre au béryllium nickelé-doré peuvent être montées tête bêche dans des trous répartis au pas de 1,905 mm.

Des dents latérales formant charnière et retenues à mi-hauteur de l'isolant peuvent être prévues aussi bien sur le pli d'une lame que sur une languette de centrage.

Chacun des intercalaires qui viennent d'être décrits peut être complété par un interposeur épais lorsqu'il doit être placé entre deux substrats qui doivent être connectés sans qu'il soit possible de les rapprocher suffisamment pour adopter un intercalaire très plat. La figure 14 montre un intercalaire suivant l'invention accolé à un interposeur épais 46. L'un des bras de la lame de contact 20 n'est pas directement en appui contre une carte de circuit imprimé. Il vient en contact avec un plongeur métallique 48 guidé par la carte 50 en matériau isolant, qui peut être fixée par des vis Parker 52 ou autrement, à la plaquette isolante 16.

Dans une autre variante encore de réalisation, montrée en figures 15 et 16, chaque lame 20 présente un tronçon rectiligne entre les deux branches destinées à s'appuyer sur les éléments à relier. Ce tronçon est emprisonné dans une fente de la plaquette isolante et ne peut s'échapper. Cette disposition permet d'adopter une densité d'implantation élevée, avec des lames imbriquées les unes sous les autres, comme indiqué sur la figure 15. La plaquette 16 peut être constituée par empilement et collage mutuel de barrettes isolantes 60 dans lesquelles sont ménagées des fuites ouvertes parallèles d'introduction des lames 20 avant empilement. La flexion des lames peut être limitée en donnant aux barrettes une section à étagements.

## Revendications

1. Intercalaire de liaison entre un boîtier micro-électronique (10) à contacts répartis sur sa face inférieure et un circuit imprimé (12), comprenant une plaquette isolante (16) percée de trous mutuellement identiques et des lames de contacts minces (20) en forme de ruban, pliées en forme de V traversant les trous et ayant, chacune, des parties terminales d'appui sur un contact et sur une plage du circuit imprimé, les trous ayant une forme apte à maintenir les lames parallèles les unes aux autres et de largeur juste suffisante pour laisser passer les lames, **caractérisé en ce que** chaque partie terminale présente un bossage d'appui (22) et **en ce que** chaque trou présente une indentation (24) de passage de bossage.

2. Intercalaire suivant la revendication 1, **caractérisé en ce que** les trous sont de forme rectangulaire, de longueur au moins égale à 5 fois leur largeur.

3. Intercalaire suivant la revendication 1 ou 2, **caractérisé en ce que** la plaquette est en isolant électrique bon conducteur de la chaleur, tel que le nitrure d'aluminium.

4. Intercalaire selon l'une quelconque des revendications précédentes, **caractérisé en ce que** les lames de contact ont approximativement 4 mm de longueur pour chaque bras, 0,8 mm de largeur et 0,1 mm d'épaisseur.

5. Intercalaire selon l'une quelconque des revendications 1 à 4, **caractérisé en ce que** le pli de chaque lame présente deux dents latérales (40) retenues à mi-hauteur de l'isolant.

6. Procédé de fabrication d'un intercalaire selon l'une quelconque des revendications 1 à 5, **caractérisé en ce qu'**on perce les trous dans la plaquette ; on découpe les lames dans une feuille ou ruban de cuivre au béryllium, on les plie en V, on les protège par dorure, on les insère dans les trous de la plaquette et on les plie collectivement, par exemple par passage à la presse.

## Claims

1. Spacer between a microelectronic package (10) with contacts distributed over its bottom side and a printed circuit (12), comprising an insulating plate (16) pierced with mutually identical holes and thin contact blades (20) in strips, folded in a V shape, crossing the holes and each having terminal sections resting on a contact and on an area of the printed circuit, the holes being of such form that they can maintain the blades parallel to each other and being of sufficient width to allow the blades to pass, **characterised in that** each terminal section has a support boss (22) and **in that** each hole has an indentation (24) for the passage of the boss.

2. Spacer according to claim 1, **characterised in that** the holes are rectangular and their length is at least equal to 5 times their width.

3. Spacer according to claim 1 or 2, **characterised in that** the plate is made of an electrical insulator which is a good conductor of heat such as aluminium nitride.

4. Spacer according to any one of the preceding claims, **characterised in that** the contact blades are approximately 4 mm long for each arm, 0.8 mm wide and 0.1 mm thick.

5. Spacer according to any one of the claims 1 to 4, **characterised in that** the fold of each blade has two lateral teeth (40) retained at mid-height of the insulator.

6. Method for manufacturing a spacer according to any one of the claims 1 to 5, **characterised in that** the holes are pierced in the plate, the blades are cut from a beryllium copper sheet or strip, folded in a V shape, protected through gold plating, inserted into the holes of the plate and folded collectively, for example by passing them through a press.

## Patentansprüche

1. Zwischenstück zur Verbindung zwischen einem Mikroelektronikgehäuse (10) mit an seiner Unterseite verteilten Kontakten und einer gedruckten Schaltung (12), umfassend eine Isolierplatte (16), in die zueinander identische Öffnungen eingelassen sind, und kleine Kontaktplättchen (20) in Streifenform, welche in V-Form gebogen sind, die Öffnungen durchqueren und jeweils Endteile zur Abstützung auf einem Kontakt und auf einem Streifen der gedruckten Schaltung aufweisen, wobei die Öffnungen eine Form aufweisen, die geeignet ist, die Plättchen parallel zueinander zu halten, und deren Breite gerade zum Einführen der Plättchen ausreicht, **dadurch gekennzeichnet, dass** jeder Endteil eine Abstütznocke (22) aufweist und dass jede Öffnung eine Einbuchtung (24) zum Einführen der Nocke aufweist.

2. Zwischenstück nach Anspruch 1, **dadurch gekennzeichnet, dass** die Öffnungen eine rechteckige Form, mit einer Länge, die mindestens gleich dem Fünffachen ihrer Breite ist, besitzen.

3. Zwischenstück nach Anspruch 1 oder 2, **dadurch gekennzeichnet, dass** die Platte aus einem gut Wärme leitenden elektrischen Nichtleiter, wie Aluminiumnitrid, besteht.

4. Zwischenstück nach einem der vorangehenden Ansprüche, **dadurch gekennzeichnet, dass** die Kontaktplättchen eine Länge an jedem Arm von ca. 4 mm sowie eine Breite von ca. 0,8 mm und eine Dicke von ca. 0,1 mm aufweisen.

5. Zwischenstück nach einem der Ansprüche 1 bis 4, **dadurch gekennzeichnet, dass** die Biegung jedes Plättchens zwei seitliche zähne (40) aufweist, die auf halber Höhe des Nichtleiters zurückgehalten werden.

6. Verfahren zur Herstellung eines Zwischenstücks nach einem der Ansprüche 1 bis 5, **gekennzeichnet durch** Einlassen der Öffnungen in die Platte, Ausschneiden der Plättchen aus einem Blatt oder einem Band aus Berylliumkupfer, Biegen der Plättchen in V-Form, Schützen der Plättchen **durch** Vergolden, Einsetzen der Plättchen in die Öffnungen der Platte und gemeinsames Biegen der Plättchen, zum Beispiel **durch** Pressen.
